(19) Europäisches Patentamt
European Patent Office
Office européen des brevets

(11) **EP 3 203 819 B1**

(12) **EUROPÄISCHE PATENTSCHRIFT**

(45) Veröffentlichungstag und Bekanntmachung des Hinweises auf die Patenterteilung:
**13.11.2019 Patentblatt 2019/46**

(51) Int Cl.:
***H05K 5/02*** (2006.01)

(21) Anmeldenummer: **16199797.8**

(22) Anmeldetag: **21.11.2016**

(54) **GEHÄUSE MIT EINER ENTFEUCHTUNGSEINRICHTUNG**

CASING WITH A DEHUMIDIFICATION DEVICE

BOÎTIER AVEC UN DÉSHUMIDIFICATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.02.2016 DE 102016101962**

(43) Veröffentlichungstag der Anmeldung:
**09.08.2017 Patentblatt 2017/32**

(73) Patentinhaber: **ebm-papst Mulfingen GmbH & Co. KG**
**74673 Mulfingen (DE)**

(72) Erfinder:
• **HUMM, Markus**
**74679 Weißbach (DE)**
• **WYSTUP, Ralph**
**74653 Künzelsau (DE)**

(74) Vertreter: **Staeger & Sperling Partnerschaftsgesellschaft mbB**
**Sonnenstraße 19**
**80331 München (DE)**

(56) Entgegenhaltungen:
**EP-A1- 1 603 379      EP-A1- 2 648 493**
**WO-A1-01/55636      US-A1- 2013 044 393**

## Beschreibung

Die Erfindung betrifft ein Gehäuse, insbesondere ein Elektronikgehäuse eines Elektromotors mit einer Entfeuchtungsvorrichtung.

Feuchtigkeit ist für elektronische Baugruppen schädlich. In Gehäusen bzw. Elektronikgehäusen werden deshalb vielfach Anstrengungen unternommen, um sowohl einen direkten Wassereintritt als auch eine Kondenswasserbildung durch Abdichtungsmaßnahmen zu verhindern. Vollständige Abdichtungen sind zwar technisch möglich, jedoch ist nicht ausgeschlossen, dass bei Temperaturschwankungen und dem damit einhergehenden wiederholten Ausdehnen und Zusammenziehen ungewollte Spalte entstehen, durch die Feuchtigkeit eindringen und der Elektronik schaden kann. Flexible Dichtungssysteme sind zwar ebenfalls bekannt, jedoch vergleichsweise aufwendig und teuer.

Als bekannter Stand der Technik ist beispielhaft die Offenbarung der WO 2013/079102 A1, WO 01/55636 A1, US 2013/044393 A1, EP 2 648 493 A1 und EP 1 603 379 A1 zu nennen.

Der Erfindung liegt deshalb die Aufgabe zugrunde, eine Entfeuchtungsvorrichtung für Gehäuse, insbesondere Elektronikgehäuse von Elektromotoren bereitzustellen, die kostengünstig zu realisieren und langzeitbeständig ist.

Diese Aufgabe wird durch die Merkmalskombination gemäß Patentanspruch 1 gelöst.

Erfindungsgemäß wird ein Gehäuse, insbesondere ein Elektronikgehäuse eines Elektromotors vorgeschlagen, mit einer Gehäusewandung, die zumindest abschnittsweise einen Aufnahmeinnenraum des Gehäuses umschließt, wobei der Aufnahmeinnenraum ausgebildet ist, eine Motorelektronik aufzunehmen. Das Gehäuse weist eine Entfeuchtungsvorrichtung mit einer eine Wandung aufweisenden Entfeuchtungskammer auf, innerhalb der hygroskopisches Material aufgenommen ist. Das hygroskopische Material ist ausgebildet, Luftfeuchtigkeit aus der Entfeuchtungskammer zu binden. Die Wandung der Entfeuchtungskammer weist zumindest eine innere dampfdurchlässige Membran, die mit einem Aufnahmeinnenraum des Gehäuses in Wirkverbindung ist, und eine äußere Membran, die mit der Außenumgebung des Gehäuses in Wirkverbindung ist, auf. Die innere und äußere Membran sind jeweils in zumindest die Richtung dampfdurchlässig, bei der ein Luftfeuchtigkeitstransport aus dem Aufnahmeinnenraum des Gehäuses durch die Entfeuchtungskammer in die Außenumgebung gewährleistbar ist, wobei die innere Membran eine geringere Feuchtigkeitspermeabilität aufweist als die äußere Membran.

Durch die Nutzung der Entfeuchtungsvorrichtung ist eine aufwendige Abdichtung des Gehäuses nicht nötig. Vielmehr wird ermöglicht, dass die Feuchtigkeit aus dem Aufnahmeinnenraum des Gehäuses durch die innere Membran in die Entfeuchtungskammer diffundiert und dort von dem hygroskopischen Material gebunden wird. Aufgrund des naturgemäß stets angestrebten Sättigungsgleichgewichts diffundiert so lange Feuchtigkeit in Form von Dampf in die Entfeuchtungskammer, bis ein Dampfdruckgleichgewicht herrscht. Gleichzeitig wird über die äußere Membran eine Feuchtigkeitsabgabe in die Außenumgebung ermöglicht, so dass die Wasseraufnahmefähigkeit des hygroskopischen Materials auf Dauer gewährleistet bleibt. Das erfindungsgemäße Entfeuchtungssystem funktioniert mit bidirektional permeablen Membranen, solange die Luftfeuchtigkeit in der Außenumgebung geringer ist als im Entfeuchtungsraum.

In einer vorteilhaften Ausführungsvariante ist vorgesehen, dass zumindest die äußere Membran wasserundurchlässig ist. Hierdurch wird sichergestellt, dass aus der Außenumgebung keine übermäßige Feuchtigkeit in die Entfeuchtungskammer eindringen kann, wodurch das hygroskopische Material mit Wasser gesättigt werden könnte. Die innere und äußere Membran können hierzu jeweils semipermeabel ausgebildet sein.

In einer Weiterbildung der Entfeuchtungsvorrichtung ist die innere Membran unidirektional dampfdurchlässig in die Entfeuchtungskammer, d.h. aus dem Aufnahmeinnenraum in die Entfeuchtungskammer hinein. Zudem ist die äußere Membran unidirektional dampfdurchlässig aus der Entfeuchtungskammer, d.h. aus der Entfeuchtungskammer hinaus an die Außenumgebung. Ein Eindringen von Feuchtigkeit aus der Außenumgebung hinein in die Entfeuchtungskammer ist somit ausgeschlossen, selbst wenn die absolute Luftfeuchtigkeit in der Außenumgebung zweitweise größer ist als im Entfeuchtungsraum.

Ferner wird gemäß der Erfindung vorgesehen, dass die innere Membran eine geringere Feuchtigkeitspermeabilität aufweist als die äußere Membran. Durch die höhere Feuchtigkeitspermeabilität der an die Außenumgebung angrenzenden äußeren Membran wird die Dampfdurchlässigkeit nach außen tendenziell vergrößert, so dass bei einer hohen Wassersättigung des hygroskopischen Materials eine Trocknung und Abdampfung in die Außenumgebung begünstigt wird.

In einem Ausführungsbeispiel der Erfindung ist die Wandung der Entfeuchtungskammer durch die innere und äußere Membran gebildet. Dabei umschließen die innere und äußere Membran das hygroskopische Material und bilden selbst vollständig die Übergänge zwischen Aufnahmeinnenraum und Außenumgebung. Die beiden Membrane können hierzu an ihren Randabschnitten beispielsweise vernäht, verklebt oder anderweitig miteinander befestigt werden, wobei stets vorgesehen ist, dass die innere Membran dem Aufnahmeinnenraum und die äußere Membran der Außenumgebung zugewandt ist.

Das hygroskopische Material ist gewählt aus Materialien mit hoher Wasseraufnahmekapazität, insbesondere Calciumchlorid ($CaCl_2$), Silikagel ($SiO_2$), Kalciumcarbonat ($K_2CO_3$) oder Zeolith.

Die innere und äußere Membran sind in einer Ausführungsvariante jeweils aus einer hochpolymeren Membran oder einer Pergamentmembran gebildet. Auch umfasst sind Ausführungen, bei denen die innere und äußere Membran aus Vliesstoff, insbesondere Polyethylenvliesstoff, oder extrudiertem Polytetrafluorethylen (PTFE) oder Polyethersulfon (PESSU) gebildet sind. Die Porengröße der Membrane liegt vorzugsweise bei bis zu 40 Nanometern. Auch können auf den Membranen zusätzliche Beschichtungen vorgesehen werden, die eine unidirektionale Dampfdurchlässigkeit begünstigen.

In einer Weiterbildung ist vorgesehen, dass die Entfeuchtungskammer beheizbar ist. Hierzu wird in einem Ausführungsbeispiel um die Entfeuchtungskammer zumindest abschnittsweise ein Heizdraht angeordnet, mittels dem die Entfeuchtungskammer und das darin befindliche hygroskopische Material aufheizbar sind. Durch die Aufheizung und mithin erhöhte Temperatur kann die als Wasser gebundene Feuchtigkeit aus dem hygroskopischen Material gelöst werden und über den durch den entstehenden Dampf erhöhten Partialdruck über die äußere Membran in die Außenumgebung abtransportiert werden. Zur sicheren Vermeidung, dass der Dampf nicht über die innere Membran diffundiert, wird erfindungsgemäß beim Vorsehen einer beheizten Entfeuchtungskammer eine unidirektionale innere Membran mit ausschließlicher Dampfströmungsrichtung in die Entfeuchtungskammer hinein bevorzugt. Ausserdem werden innere und äußere Membrane mit unterschiedlicher Permeabilität eingesetzt, bei dem die äußere Membran einen geringeren Widerstand bietet und so das Konzentrations- und Druckgefälle über letztere ausgeglichen wird.

In einer Ausführungsvariante ist der Heizdraht als Hitzdraht ausgeführt. Der Hitzdraht ist dadurch gekennzeichnet, dass er eine temperaturabhängige Änderung des Drahtwiderstandes aufweist, der wiederum messbar ist. Durch die Messung des Drahtwiderstands kann auf einfachem Wege eine Regelung der Temperatur bzw. der gewünschten Heizleitung erreicht werden.

Ferner ist in einem Ausführungsbeispiel vorgesehen, dass in der Entfeuchtungskammer ein Feuchtigkeitsmesssensor angeordnet ist. Alternativ oder zusätzlich wird in der Entfeuchtungskammer eine die Feuchtigkeitssättigung des hygroskopischen Materials messende Feuchtigkeitsmessvorrichtung vorgesehen. Die Feuchtigkeitsmessvorrichtung wird in einer Ausführung beispielhaft durch einen elektrischen Leitfähigkeitsmesser realisiert, dessen Signale über ein Steuergerät erfassbar sind. Es ist mithin eine Schaltung verwirklichbar, bei der eine Ansteuerung der Heizung der Entfeuchtungskammer bzw. des hygroskopischen Materials in Abhängigkeit von einem Messwert der absoluten Feuchtigkeit im Entfeuchtungsraum bzw. der Sättigung des hygroskopischen Materials erfolgt. Sobald ein Grenzwert der Wasseraufnahme erreicht ist, wird die Heizung zur Trocknung eingesetzt.

In einer vorteilhaften Ausführungsvariante ist die Entfeuchtungskammer als auswechselbare und/oder nachrüstbare Moduleinheit ausgebildet. Sie kann somit an bestehende Gehäuse eingesetzt oder im Bedarfsfall einfach ausgetauscht werden. Auch ist ermöglicht, die Entfeuchtungsleistung der einzelnen Entfeuchtungskammern unterschiedlich stark einzustellen und die einzusetzende Entfeuchtungskammern an den jeweiligen Einsatzzweck anzupassen. So können Standardgehäuse für alle Einsätze produziert werden, die mit unterschiedlichen Entfeuchtungsvorrichtungen ausgestattet werden können.

Zudem umfasst die Erfindung einen Elektromotor mit einer Motorelektronik in einem Elektronikgehäuse, wobei die Motorelektronik ein Leistungsmodul aufweist, das angrenzend an die Entfeuchtungsvorrichtung angeordnet ist, so dass im Betrieb des Elektromotors durch das Leistungsmodul erzeugte Wärme auf die Entfeuchtungsvorrichtung übertragbar ist, um die Entfeuchtungskammer aufzuheizen. Die Heizung der Entfeuchtungskammer kann somit ohne zusätzliche Bauteile erfolgen, sie wird durch das ohnehin eingesetzte und ausreichend Wärme erzeugende Leistungsmodul verwirklicht. Sollte für eine längere Zeit die dafür erforderliche Temperatur des Leistungsmoduls nicht erreicht werden, wird in einer Ausführung das Leistungsmodul selektiv so angesteuert, dass es sich zwar erhitzt, die Funktion des Gerätes aber nicht signifikant ändert. Zudem wird die Modultemperatur des Leistungsmoduls über einen im Leistungsmodul eingebauten Temperatursensor erfasst.

Die vorstehend beschriebenen Merkmale sind beliebig kombinierbar, soweit sie nicht konfligieren und dies technisch möglich ist.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen beispielhaft schematisch:

Fig. 1    eine Entfeuchtungsvorrichtung montiert in einem Gehäuse;

Fig. 2    eine Entfeuchtungsvorrichtung montiert auf einem Leistungsmodul in einem Gehäuse;

Fig. 3    eine Entfeuchtungsvorrichtung als Moduleinheit montiert in einer Gehäusewandung.

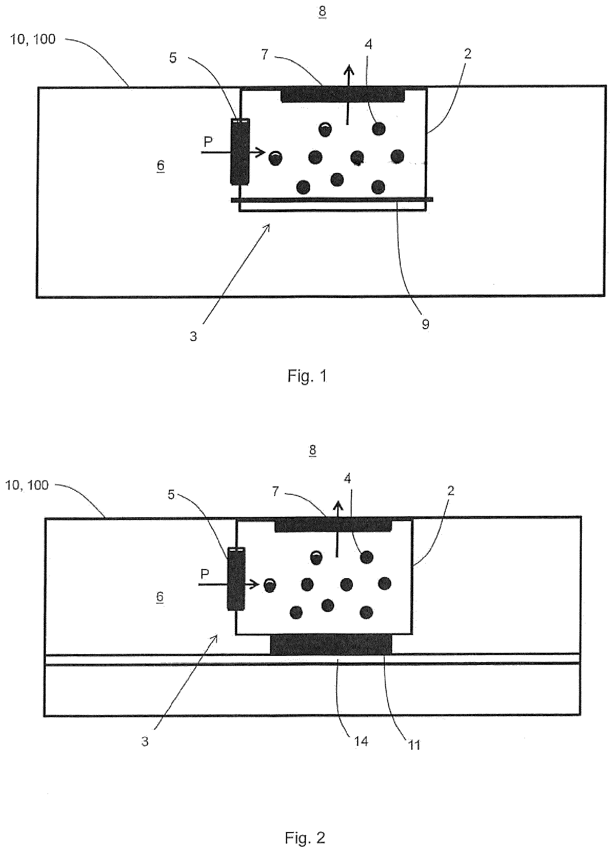

In Figur 1 ist eine schematische Ansicht einer Entfeuchtungsvorrichtung 1 montiert in einem Gehäuse 10, das auch als Elektronikgehäuse 100 eines Elektromotors dienen kann, dargestellt. Die Entfeuchtungsvorrichtung 1 weist eine Entfeuchtungskammer 3 auf, in der an verschiedenen Stellen verteilt hygroskopisches Material 4 aufgenommen ist. Zur Vergrößerung der Gesamtoberfläche und damit zur Erhöhung der Wasserbindungsgeschwindigkeit ist das hygroskopische Material 4 an mehreren Stellen innerhalb der Entfeuchtungskammer 3 verteilt. An der Wandung 2 der Entfeuchtungskammer 3 ist angrenzend an den Aufnahmeinnenraum 6 des Gehäuses 10 die innere dampfdurchlässige Membran 5 und angrenzend an die Außenumgebung 8 des Gehäuses 10 die äußere dampfdurchlässige Membran 7 vorgesehen. Die innere und äußere Membran 5, 7 bilden dabei jeweils eine Teilfläche der Wandung 2 der Entfeuchtungskammer 3. In der gezeigten Ausführung sind die innere und äußere Membran 5, 7 jeweils in Pfeilrichtung P dampfdurchlässig und ermöglichen einen Luftfeuchtigkeitstransport aus dem Aufnahmeinnenraum 6 des Gehäuses 10 durch die Entfeuchtungskammer 3 in die Außenumgebung 8. Das Dampfdruckgefälle zwischen dem Aufnahmeinnenraum 6 des Gehäuses 10 und dem Inneren der Entfeuchtungskammer 3 wird durch das hygroskopische Material 4 erzeugt. Bei erhöhter Feuchtigkeit im Gehäuseinneren, beispielsweise durch Kondensation, ist die absolute Luftfeuchtigkeit innerhalb der Entfeuchtungskammer 3 aufgrund des hygroskopischen Materials 4 geringer als innerhalb des Gehäuses 10, so dass über die innere Membran 5 ein Sättigungs- und Druckausgleich erfolgt. Die Luftfeuchtigkeit wird von den hygroskopischen Material 4 als Wasser gebunden. Bei starker Entfeuchtung kann die absolute Feuchtigkeit innerhalb der Entfeuchtungskammer 3 größer werden als im Bereich der Außenumgebung 8. Dann wird über die äußere Membran 7 Feuchtigkeit aus der Entfeuchtungskammer 3 an die Außenumgebung 8 abgegeben. Die innere und äußere Membran 5, 7 sind in Pfeilrichtung P unidirektional permeabel und wasserundurchlässig.

Zur Regeneration des hygroskopischen Materials 4 ist als Ausführungsvariante um die Entfeuchtungskammer 3 ein als Hitzdraht ausgeführter Heizdraht 9 angeordnet. Über den Heizdraht 9 kann die Entfeuchtungskammer 3 und das darin befindliche hygroskopische Material 4 derart stark erwärmt werden, dass das gebundene Wasser ausdampft und das hygroskopische Material 4 wieder seinen vollen oder im Wesentlichen vollen Wasseraufnahmekoeffizienten w des jeweiligen hygroskopischen Materials aufweist.

Dabei gilt:

$$w = \frac{m}{A \times \sqrt{t}}$$

m und A stehen für Masse und Grundfläche des hygroskopischen Materials und t für die Zeit. Für die Erfindung werden als "saugend" klassifizierte Materialien mit einem Wert des Wasseraufnahmekoeffizienten

$$w > 2 kg/m^2 h^{0,5},$$

beispielsweise Calciumchlorid, eingesetzt. Die innere und äußere Membran 5, 7 sind aus extrudiertem PTFE und in die Wandung 2 des Gehäuses 10, 100 als flächiger Wandteil eingespannt.

Figur 2 weist eine Entfeuchtungskammer 3 mit den Merkmalen aus Figur 1 auf, so dass auf diesbezügliche Wiederholungen verzichtet wird. Jedoch ist die Entfeuchtungskammer 3 auf einem auf einer Leiterplatte 14 befindlichen Leistungsmodul 11 einer Motorelektronik angeordnet. Sowohl die Leiterplatte 14 als auch das Leistungsmodul 11 befinden sich innerhalb des Aufnahmeraums 6 des Gehäuses 10 bzw. Elektronikgehäuses 100. Das Leistungsmodul 11 ist selektiv ansteuerbar, so dass es auch nur Wärme erzeugen kann, ohne die Gerätefunktion bzw. Motorfunktion zu beeinflussen. Über die Wärmeerzeugung kann als alternative Ausführung zum Heizdraht die Entfeuchtungskammer 3 aufgeheizt und das hygroskopische Material 4 getrocknet werden. Der Feuchtigkeitstransport erfolgt auch bei dieser Ausführung gemäß der Pfeilrichtung P aus dem Aufnahmeinnenraum 6 an die Außenumgebung 8.

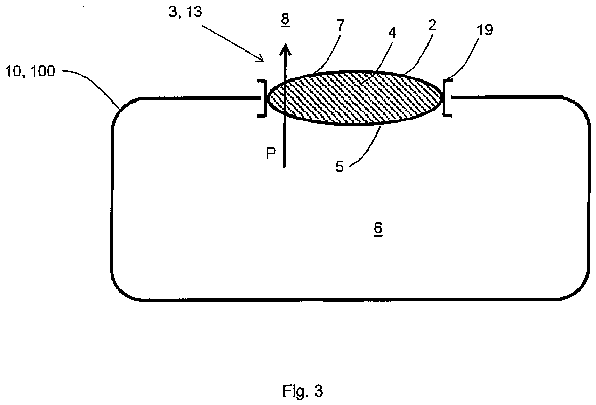

In Figur 3 ist beispielhaft schematisch eine als auswechselbare, nachrüstbare Moduleinheit 13 ausgebildete Entfeuchtungskammer 3 dargestellt. Die gesamte Wandung der Entfeuchtungskammer 3 wird durch die innere und äußere Membran 5, 7 selbst gebildet. Zwischen der inneren und äußeren Membran 5, 7 ist das hygroskopische Material 4 aufgenommen. Die als Moduleinheit 13 ausgebildete Entfeuchtungskammer 3 wird über entsprechende Aufnahmen 19 innerhalb der Gehäusewand befestigt und trennt den zu entfeuchtenden Aufnahmeraum 6 von der Außenumgebung 8, so dass der Feuchtigkeitstransport auch bei dieser Ausführung gemäß der Pfeilrichtung P erfolgt. Auch wenn die Figur das hygroskopische Material 4 als die Entfeuchtungskammer 13 vollständig füllend zeigt, sind Ausführungen umfasst, bei denen das hygroskopische Material 4 nur partiell und/oder verteilt vorgesehen ist, so dass ein Luftstrom durch die Entfeuchtungskammer 3 gewährleistbar ist.

Die Erfindung beschränkt sich in ihrer Ausführung nicht auf die vorstehend angegebenen bevorzugten Ausführungsbeispiele. Beispielsweise können als Membrane auch im Markt bekannte Materialien wie z.B. Tyvek (eingetragene Marke), insbesondere Typ 16 verwendet werden, welche die erfindungsgemäßen technischen Voraussetzungen der Dampfdurchlässigkeit erfüllen. Zudem kann das hygroskopische Material in der Entfeuchtungskammer auch mit derartigem Material eingewickelt sein. Weitere Alternativen für das Membranmaterial sind beispielsweise Pergament oder Tonzellen mit Einlagerungen von z.B. Kupferhexacyanoferrat(II) oder Celluloseacetat.

**Patentansprüche**

1. Gehäuse, insbesondere ein Elektronikgehäuse (100) eines Elektromotors, mit einer Gehäusewandung, die zumindest abschnittsweise einen Aufnahmeinnenraum (6) des Gehäuses (10) umschließt, wobei der Aufnahmeinnenraum (6) ausgebildet ist, eine Motorelektronik aufzunehmen, wobei das Gehäuse (10) eine Entfeuchtungsvorrichtung mit einer eine Wandung (2) aufweisenden Entfeuchtungskammer (3) aufweist, innerhalb der hygroskopisches Material (4) aufgenommen ist, welches ausgebildet ist, Luftfeuchtigkeit aus der Entfeuchtungskammer (3) zu binden, wobei die Wandung (2) der Entfeuchtungskammer (3) zumindest eine innere dampfdurchlässige Membran (5) aufweist, die mit einem Aufnahmeinnenraum (6) des Gehäuses (10) in Wirkverbindung ist, und eine äußere Membran (7) aufweist, die mit einer Außenumgebung (8) des Gehäuses (10) in Wirkverbindung ist, wobei die innere und äußere Membran (5, 7) jeweils in zumindest eine Richtung dampfdurchlässig sind, bei der ein Luftfeuchtigkeitstransport aus dem Aufnahmeinnenraum (6) des Gehäuses (10) durch die Entfeuchtungskammer (3) in die Außenumgebung (8) gewährleistbar ist, wobei die innere Membran (5) eine geringere Feuchtigkeitspermeabilität aufweist als die äußere Membran (7).

2. Gehäuse nach Anspruch 1, **dadurch gekennzeichnet, dass** zumindest die äußere Membran (7) wasserundurchlässig ist.

3. Gehäuse nach Anspruch 1 oder 2, **dadurch gekennzeichnet, dass** die innere Membran (5) unidirektional in die Entfeuchtungskammer (3) dampfdurchlässig ist und die äußere Membran (7) unidirektional aus der Entfeuchtungskammer (3) dampfdurchlässig ist.

4. Gehäuse nach zumindest einem der vorigen Ansprüche, **dadurch gekennzeichnet, dass** die innere und äußere Membran (5, 7) jeweils semipermeabel ausgebildet sind.

5. Gehäuse nach zumindest einem der vorigen Ansprüche, **dadurch gekennzeichnet, dass** die Wandung der Entfeuchtungskammer (3) durch die innere und äußere Membran (5, 7) gebildet ist.

6. Gehäuse nach zumindest einem der vorigen Ansprüche, **dadurch gekennzeichnet, dass** das hygroskopische Material (4) aus Calciumchlorid (CaCl$_2$), Silikagel (SiO$_2$), Kalciumcarbonat (K$_2$CO$_3$) oder Zeolith ist.

7. Gehäuse nach zumindest einem der vorigen Ansprüche, **dadurch gekennzeichnet, dass** die innere und äußere Membran (5, 7) jeweils aus einer hochpolymeren Membran oder einer Pergamentmembran gebildet sind.

8. Gehäuse nach zumindest einem der vorigen Ansprüche 1 bis 6, **dadurch gekennzeichnet, dass** die innere und äußere Membran (5, 7) aus Vliesstoff, insbesondere Polyethylenvliesstoff, oder extrudiertem Polytetrafluorethylen (PTFE) oder Polyethersulfon (PESU) gebildet sind.

9. Gehäuse nach zumindest einem der vorigen Ansprüche, **dadurch gekennzeichnet, dass** die Entfeuchtungskammer (3) beheizbar ist.

10. Gehäuse nach zumindest einem der vorigen Ansprüche, **dadurch gekennzeichnet, dass** um die Entfeuchtungskammer (3) zumindest abschnittsweise ein Heizdraht (9) angeordnet ist, mittels dem die Entfeuchtungskammer (3) und das hygroskopische Material (4) aufheizbar sind.

11. Gehäuse nach zumindest einem der vorigen Ansprüche) **dadurch gekennzeichnet, dass** in der Entfeuchtungskammer (3) ein Feuchtigkeitsmesssensor vorgesehen ist.

12. Gehäuse nach zumindest einem der vorigen Ansprüche, **dadurch gekennzeichnet, dass** in der Entfeuchtungskammer (3) eine die Feuchtigkeitssättigung des hygroskopischen Materials (4) messende Feuchtigkeitsmessvorrichtung vorgesehen ist.

13. Gehäuse nach zumindest einem der vorigen Ansprüche, **dadurch gekennzeichnet, dass** die Entfeuchtungskammer (3) als auswechselbare und/oder nachrüstbare Moduleinheit (13) ausgebildet ist.

14. Elektromotor mit einer Motorelektronik in einem Elektronikgehäuse (100) nach einem der vorigen Ansprüche, **dadurch gekennzeichnet, dass** die Motorelektronik ein Leistungsmodul (11) aufweist, das angrenzend an die Entfeuchtungsvorrichtung (1) angeordnet ist, so dass im Betrieb des Elektromotors durch das Leistungsmodul (11) erzeugte Wärme auf die Entfeuchtungsvorrichtung (1) übertragbar ist, um die Entfeuchtungskammer (3) aufzuheizen.

## Claims

1. Housing, particularly an electronics housing (100) of an electric motor, having a housing wall enclosing at least in sections a receiver interior (6) of the housing (10), the receiver interior (6) is formed to receive a motor electronics, the housing (10) comprising a dehumidification device having a dehumidification chamber (3) comprising a wall (2), within said dehumidification chamber (3) hygroscopic material (4) is incorporated formed to bind air humidity from the dehumidification chamber (3), wherein the wall (2) of the dehumidification chamber (3) comprises at least one inner vapour-permeable membrane (5) operatively connected to a receiver interior (6) of the housing (10), and an outer membrane (7) operatively connected to an outer environment (8) of the housing (10), said inner and outer membranes (5, 7) are respectively vapour-permeable in at least one direction, in which an air humidity transport from the receiver interior (6) of the housing (10) through the dehumidification chamber (3) to the outer environment (8) is ensureable, said inner membrane (5) having a lower humidity permeability than the outer membrane (7).

2. Housing according to claim 1, **characterized in that** at least the outer membrane (7) is impermeable to water.

3. Housing according to claim 1 or 2, **characterized in that** the inner membrane (5) is unidirectionally vapour-permeable into the dehumidification chamber (3) and the outer membrane (7) is unidirectionally vapour-permeable out of the dehumidification chamber (3).

4. Housing according to at least one of the preceding claims, **characterized in that** the inner and outer membranes (5, 7) are respectively formed semipermeable.

5. Housing according to at least one of the preceding claims, **characterized in that** the wall of the dehumidification chamber (3) is formed by the inner and outer membrane (5, 7).

6. Housing according to at least one of the preceding claims, **characterized in that** the hygroscopic material (4) is calcium chloride (CaCl2), silica gel (SiO2), calcium carbonate (K2CO3) or zeolite.

7. Housing according to at least one of the preceding claims, **characterized in that** the inner and outer membranes (5, 7) are respectively formed from a high-polymer membrane or a vellum membrane.

8. Housing according to at least one of the preceding claims 1 to 6, **characterized in that** the inner and outer membranes (5, 7) are formed from nonwoven fabric, particularly polyethylene nonwoven fabric, or extruded polytetrafluoroethylene (PTFE) or polyethersulfone (PESU).

9. Housing according to at least one of the preceding claims, **characterized in that** the dehumidification chamber (3) is heatable.

10. Housing according to at least one of the preceding claims, **characterized in that** a heating wire (9) is arranged at least in sections around the dehumidification chamber (3), by means of said heating wire the dehumidification chamber (3) and the hygroscopic material (4) are heatable.

11. Housing according to at least one of the preceding claims, **characterized in that** a humidity measuring sensor is provided in the dehumidification chamber (3).

12. Housing according to at least one of the preceding claims, **characterized in that** a humidity measuring device measuring the humidity saturation of the hygroscopic material (4) is provided in the dehumidification chamber (3).

13. Housing according to at least one of the preceding claims, **characterized in that** the dehumidification chamber (3) is designed as an exchangeable and/or retrofittable modular unit (13).

14. Electric motor having a motor electronics in an electronics housing (100) according to one of the preceding claims, **characterized in that** the motor electronics has a power module (11) arranged adjacent to the dehumidifying device (1) so that heat generated by the power module (11) during operation of the electric motor can be transferred to the dehumidifying device (1) in order to heat up the dehumidifying chamber (3).

**Revendications**

1. Boîtier, en particulier boîtier électronique (100) d'un moteur électrique, avec une paroi de boîtier, qui enferme au moins par section un espace intérieur de logement (6) du boîtier (10), dans lequel l'espace intérieur de logement (6) est réalisé pour recevoir une électronique du moteur, dans lequel le boîtier (10) présente un déshumidificateur avec une chambre de déshumidification (3) présentant une paroi (2), à l'intérieur de laquelle du matériau hygroscopique (4) est reçu, lequel est réalisé pour lier l'humidité de l'air de la chambre de déshumidification (3), dans lequel la paroi (2) de la chambre de déshumidification (3) présente au moins une membrane perméable à la vapeur intérieure (5), qui est en liaison active avec un espace intérieur de logement (6) du boîtier (10), et une membrane extérieure (7), qui est en liaison active avec un environnement extérieur (8) du boîtier (10), dans lequel la membrane intérieure et extérieure (5, 7) sont perméables à la vapeur respectivement dans au moins une direction, dans laquelle un transport d'humidité de l'air de l'espace intérieur de logement (6) du boîtier (10) par la chambre de déshumidification (3) à l'environnement extérieur (8) peut être garanti, dans lequel la membrane intérieure (5) présente une perméabilité à l'humidité inférieure à celle de la membrane extérieure (7).

**2.** Boîtier selon la revendication 1, **caractérisé en ce qu'**au moins la membrane extérieure (7) est imperméable à l'eau.

**3.** Boîtier selon la revendication 1 ou 2, **caractérisé en ce que** la membrane intérieure (5) est perméable à la vapeur de manière unidirectionnelle dans la chambre de déshumidification (3) et la membrane extérieure (7) est perméable à la vapeur de manière unidirectionnelle depuis la chambre de déshumidification (3).

**4.** Boîtier selon au moins une des revendications précédentes, **caractérisé en ce que** la membrane intérieure et extérieure (5, 7) sont réalisées respectivement de manière semi-perméable.

**5.** Boîtier selon au moins une des revendications précédentes, **caractérisé en ce que** la paroi de la chambre de déshumidification (3) est formée par la membrane intérieure et extérieure (5, 7).

**6.** Boîtier selon au moins une des revendications précédentes, **caractérisé en ce que** le matériau hygroscopique (4) est en chlorure de calcium ($CaCl_2$), gel de silicium ($SiO_2$), carbonate de calcium ($K_2CO_3$) ou zéolithe.

**7.** Boîtier selon au moins une des revendications précédentes, **caractérisé en ce que** la membrane intérieure et extérieure (5, 7) sont formées respectivement en une membrane haut polymère ou une membrane de parchemin.

**8.** Boîtier selon au moins une des revendications précédentes 1 à 6, **caractérisé en ce que** la membrane intérieure et extérieure (5, 7) est en non-tissé, en particulier non-tissé en polyéthylène, ou polytétrafluoroéthylène extrudé (PTFE) ou polyéthersulfone (PESU).

**9.** Boîtier selon au moins une des revendications précédentes, **caractérisé en ce que** la chambre de déshumidification (3) peut être chauffée.

**10.** Boîtier selon au moins une des revendications précédentes, **caractérisé en ce qu'**un fil chauffant (9) est agencé au moins par section autour de la chambre de déshumidification (3), au moyen duquel la chambre de déshumidification (3) et le matériau hygroscopique (4) peuvent être chauffés.

**11.** Boîtier selon au moins une des revendications précédentes, **caractérisé en ce qu'**un capteur de mesure d'humidité est prévu dans la chambre de déshumidification (3).

**12.** Boîtier selon au moins une des revendications précédentes, **caractérisé en ce qu'**un dispositif de mesure d'humidité mesurant la saturation en humidité du matériau hygroscopique (4) est prévu dans la chambre de déshumidification (3).

**13.** Boîtier selon au moins une des revendications précédentes, **caractérisé en ce que** la chambre de déshumidification (3) est réalisée en tant qu'unité de module (13) échangeable et/ou rééquipable.

**14.** Moteur électrique avec une électronique de moteur dans un boîtier électronique (100) selon l'une quelconque des revendications précédentes, **caractérisé en ce que** l'électronique de moteur présente un module de puissance (11), qui est agencé de manière adjacente au déshumidificateur (1) de sorte que la chaleur générée en fonctionnement du moteur électrique par le module de puissance (11) peut être transférée au déshumidificateur (1) pour chauffer la chambre de déshumidification (3).

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013079102 A1
- WO 0155636 A1
- US 2013044393 A1
- EP 2648493 A1
- EP 1603379 A1